# EUROPEAN PATENT SPECIFICATION

(11) **EP 4 228 014 B1**
(45) Date of publication and mention of the grant of the patent: **12.03.2025**
(21) Application number: 21885962.7
(22) Date of filing: 18.10.2021
(51) Int. Cl.: B81B 3/00, C23C 14/08, C23C 14/32, G02B 26/08, G02B 26/10, H10N 30/06, H10N 30/079, H10N 30/00, H10N 30/20, H10N 30/853, H10N 30/87

(54) **PIEZOELECTRIC ELEMENT AND METHOD FOR MANUFACTURING PIEZOELECTRIC ELEMENT**
PIEZOELEKTRISCHES ELEMENT UND VERFAHREN ZUR HERSTELLUNG EINES PIEZOELEKTRISCHEN ELEMENTS
ÉLÉMENT PIÉZOÉLECTRIQUE ET PROCÉDÉ DE FABRICATION D'ÉLÉMENT PIÉZOÉLECTRIQUE

(30) Priority: 02.11.2020 JP 2020183527
(43) Date of publication of application: 16.08.2023
(73) Proprietor: STANLEY ELECTRIC CO., LTD., Tokyo 153-8636 (JP)
(72) Inventor: TANAKA, Haruki, Tokyo 153-8636 (JP)
(74) Representative: Carstens, Dirk Wilhelm
(86) International application number: PCT/JP2021/038453
(87) International publication number: WO 2022/091843

(56) References cited:
- JP-A- 2011 093 788
- JP-A- 2013 197 522
- JP-A- 2015 195 343
- JP-A- 2016 219 603
- US-A1- 2016 341 956
- US-A1- 2017 253 040
- YU ET AL: "Distribution in orientation axis of thin film grown by pulsed laser deposition", THIN SOLID FILMS, ELSEVIER, AMSTERDAM, NL, vol. 516, no. 6, 23 December 2007 (2007-12-23), pages 907 - 911, XP022400156, ISSN: 0040-6090, DOI: 10.1016/J.TSF.2007.04.150
- GOH W C ET AL: "Microstructure and growth mode at early growth stage of laser-ablated epitaxial Pb(Zr0.52Ti0.48)O3 films on a SrTiO3 substrate", JOURNAL OF APPLIED PHYSICS, AMERICAN INSTITUTE OF PHYSICS, 2 HUNTINGTON QUADRANGLE, MELVILLE, NY 11747, vol. 89, no. 8, 15 April 2001 (2001-04-15), pages 4497 - 4502, XP012053314, ISSN: 0021-8979, DOI: 10.1063/1.1356426

## Description

### Technical Field

The present invention relates to a piezoelectric element used for a light deflector and the like, and a method for manufacturing the piezoelectric element.

### Background Art

In recent years, there is an increasing need for sensor elements and actuator elements configured by systems having microstructures such as MEMS (Micro Electro Mechanical Systems). Hence, the development of a direct thin film forming method for forming a piezoelectric crystal film directly on a silicon wafer is progressing.

In particular, in piezoelectric actuators for MEMS using crystal films of lead zirconate titanate (PZT) as a piezoelectric material, orientation control is essential to obtain high piezoelectric properties.

For example, the piezoelectric actuator of JP 2008-035600 A has a support and piezoelectric bodies formed on the support, and includes a plurality of piezoelectric cantilevers that bend and deform by piezoelectric drive. Further, the piezoelectric actuator independently includes a plurality of electrodes for applying drive voltages to the piezoelectric bodies of the plurality of piezoelectric cantilevers. The end portions of the plurality of piezoelectric cantilevers are mechanically connected such that the bend and deformation of each piezoelectric cantilever can be accumulated, and each piezoelectric cantilever is independently bent and deformed by the application of the drive voltage.

In the above-described piezoelectric actuator, the torque generated at the distal end portion of the piezoelectric cantilever and the amount of displacement thereof depend on the piezoelectric properties of the piezoelectric bodies and the size of the cantilevers. In other words, in order to obtain high piezoelectric properties, it is preferable to control the crystal orientation of the crystal film of a piezoelectric material.

US 2017/253040 A1 discloses an electromechanical transducer element, a liquid discharge head, a liquid discharge device, and a liquid discharge apparatus und was used as a basis for the preamble of claim 1.

YU ET AL, "Distribution in orientation axis of thin film grown by pulsed laser deposition", THIN SOLID FILMS, ELSEVIER, AMSTERDAM, NL, December 23, 2007, vol. 516, no. 6, doi:10.1016/J.TSF.2007.04.150, ISSN 0040-6090, pages 907 - 911, discloses that orientations of LaNiO₃ (LNO) and Pb(Zr_{0.52}Ti_{0.48})TiO₃ (PZT) films deposited by laser ablation were evaluated using X-ray diffraction. (001)-oriented PZT and LNO films were achieved under optimized deposition conditions. Pole-figure measurements of both LNO and PZT films showed that (001) out-of-plan orientation was affected by plume direction. It was found that the (001) axes of both LNO and PZT films at locations away from the plume center were significantly tilted. The incline angle of tilt increases with the distance away from the center of the plume. The films grown in columnar structures and the column axis coincided with the crystalline orientation. Polarization of the PZT film was slightly affected by the difference in orientation tilt angles of the film investigated.

US 2016/341956 A1 discloses a piezoelectric device which includes a substrate; an insulating layer provided on the substrate; a lower electrode layer provided on the insulating layer; a piezoelectric structure provided on the lower electrode layer, the piezoelectric structure including at least one conductive layer and multiple piezoelectric layers sandwiching the conductive layer, the conductive layer having the same crystal structure as that of the piezoelectric layers; and an upper electrode layer provided on the piezoelectric structure.

GOH W C ET AL, "Microstructure and growth mode at early growth stage of laser-ablated epitaxial Pb(Zr0.52Ti0.48)O3 films on a SrTiO3 substrate", JOURNAL OF APPLIED PHYSICS, AMERICAN INSTITUTE OF PHYSICS, 2 HUNTINGTON QUADRANGLE, MELVILLE, NY 11747, April 15, 2001, vol. 89, no. 8, doi:10.1063/1.1356426, ISSN 0021-8979, pages 4497 - 4502, discloses that the surface morphology and microstructure of laser-ablated Pb(Zr_{0.52}Ti_{0.48})O₃ (PZT) films on a (100) SrTiO₃ (STO) substrate at early growth stage are characterized by means of atomic-force microscope, x-ray diffraction, and high-resolution transmission electron microscopy analysis. The (100) STO surface is found to be very favorable for epitaxial growth of (001) PZT films, which undergo a three-dimensional island growth mode. We observed a two-layer structure at the film thickness around 40-50 nm when small nuclei/grains merge into large grains. With further increase of film thickness, a column-like growth mode dominates the film crystalline structure, which results in an almost independent in-plain grain size of 100-150 nm with increasing film thickness and a limited film roughness. A very sharp interface between the PZT thin film and STO substrate is observed. The PZT film shows a perfect stacking lattice at a thickness of around 20 nm and above, indicating that the misalignment due to the interface stress and defects is healed after stacking about 50 ML of the film. These results have shed some light on the growth mechanism of epitaxial PZT film on YBCO or other bottom layers for microelectromechanical systems application.

### Summary of Invention

### Technical Problem

It has been possible to obtain high piezoelectric properties by controlling the crystal orientation of a PZT crystal film, which is a piezoelectric material used for a piezoelectric actuator (piezoelectric element). However, there has been a problem that the piezoelectric element cannot provide a sufficient endurance time.

The present invention has been made in view of the above-described circumstances, and it is an object of the invention to provide a piezoelectric element that improves endurance time while controlling the crystal orientation of the piezoelectric material of a piezoelectric element, and a method for manufacturing the piezoelectric element.

### Solution to Problem

A piezoelectric element according to the invention is provided as set forth in claim 1. Preferred embodiments of the present invention may be gathered from the dependent claims.

The piezoelectric element according to the present invention includes the first electrode film, the tetragonal piezoelectric crystal film on the first electrode film, and the second electrode film provided on the piezoelectric crystal film. Here, the term "on" includes the case of no direct contact with a film on the lower surface side. The tetragonal crystal is a crystal in which axial lengths a, b, and c of a unit cell have a relationship of a=b≠c. In addition, a <100> direction of the tetragonal crystal is an a-axis direction, a <010> direction is a b-axis direction, and a <001> direction is a c-axis direction, and the planes perpendicular to a <001> axis are a (001) surface and a c-plane.

The piezoelectric crystal film (columnar crystal grain boundary) of the present invention includes the perpendicularly oriented part and the obliquely oriented part having the c-axis oriented at an angle with respect to the c-axis of the perpendicularly oriented part. Further, the piezoelectric crystal film is displaced without impairing the properties thereof when a voltage is applied (when the voltage is increased), and returns to the original state thereof when the application is stopped (when the voltage is decreased). The piezoelectric crystal film including the obliquely oriented part of the present invention has a higher withstand voltage than a piezoelectric crystal film composed of only a perpendicularly oriented part. Further, in the piezoelectric crystal film, the c-axis distribution of the obliquely oriented part is discrete with respect to the c-axis distribution of the perpendicularly oriented part. Thus, it is possible to obtain a piezoelectric element with high long-term reliability due to the high withstand voltage without degrading the performance of the piezoelectric element.

In the piezoelectric element according to the present invention, the c-axis of the obliquely oriented part is preferably inclined in all circumferential directions from 0° to 360°, using the c-axis of the perpendicularly oriented part as the rotation axis thereof.

The c-axis of the perpendicularly oriented part is in the direction perpendicular to a plane of a substrate, whereas the c-axis of the obliquely oriented part is inclined in all circumferential directions (0° to 360°), using the c-axis of the perpendicularly oriented part as the rotation axis thereof. For this reason, the c-axis of the obliquely oriented part extends at any angle in a radial direction with respect to the c-axis of the perpendicularly oriented part.

Further, in piezoelectric element according to the present invention, a tilt angle φ of the c-axis of the obliquely oriented part with respect to the c-axis of the perpendicularly oriented part of the piezoelectric crystal film is preferably greater than 6° and below 19°.

The tilt angle φ of the c-axis of the obliquely oriented part is set to be greater than 6° and below 19°. This enables the piezoelectric crystal film including the obliquely oriented part to improve electric field resistance and endurance time and to prevent degradation of the piezoelectric properties.

In addition, in the piezoelectric element according to the present invention, an intensity ratio Rp in an X-ray rocking curve of the obliquely oriented part to the perpendicularly oriented part is 0.1 to 1.

In the piezoelectric element, setting the intensity ratio Rp to the range of 0.1 to 1 makes it possible to enhance the effect by the obliquely oriented part. Thus, it is possible to prevent degradation of the piezoelectric properties due to an increase in orientation disorder of the piezoelectric crystal film.

Further, in the piezoelectric element according to the present invention, preferably, the piezoelectric crystal film is made of lead zirconate titanate (PZT) and the first electrode film is made of platinum (Pt).

According to the present invention, lead zirconate titanate (PZT) and platinum (Pt), which are the most suitable materials for the piezoelectric crystal film and the first electrode film, respectively, are used therefor. In particular, a piezoelectric element is created using PZT, which has high piezoelectric properties, as the piezoelectric crystal film. This makes it possible to, for example, perform high-speed drive at a low voltage to obtain a large scanning angle when the piezoelectric element is applied to an optical scanner module.

Further, in the piezoelectric element according to the present invention, the film surface of the first electrode film is preferably a (111) surface.

Setting the film surface of the first electrode film to a (111) surface makes it possible to improve the crystal orientation characteristics of the piezoelectric crystal film on the upper surface of the first electrode film when the piezoelectric crystal film is formed.

A method for manufacturing a piezoelectric element includes the steps of: depositing an amorphous metal oxide on a substrate, at least one surface of which is a plane; forming, on the metal oxide, a first electrode film made of a conductive metal film, a film forming surface of which is a (111) surface; forming an SRO film on the first electrode film; forming, on the SRO film, a piezoelectric crystal film, which is a tetragonal uniaxially oriented polycrystalline body having columnar crystal grains in a direction perpendicular to the first electrode film, and which has a perpendicularly oriented part having a c-axis in a direction perpendicular to the first electrode film and an obliquely oriented part having a c-axis inclined at a tilt angle φ with respect to the c-axis of the perpendicularly oriented part within a range of greater than 6° and below 19° in the columnar crystal grains; and forming a second electrode film provided on a surface of the piezoelectric crystal film, the surface facing the first electrode film.

The method for manufacturing a piezoelectric element includes the steps of depositing a metal oxide on a substrate, forming the first electrode film, forming the SRO film, forming the piezoelectric crystal film, and forming the second electrode film. The piezoelectric crystal film includes the perpendicularly oriented part and the obliquely oriented part having the c-axis oriented at an angle from the c-axis of the perpendicularly oriented part (the tilt angle φ of the c-axis being greater than 6° and below 19°). The obliquely oriented part is displaced without impairing the properties thereof when a voltage is applied thereto (when the voltage is increased), and returns to the original state thereof when the application is stopped (when the voltage is decreased). This piezoelectric crystal film has a higher withstand voltage than a piezoelectric crystal film composed of only a perpendicularly oriented part. Thus, the performance of the piezoelectric element is not degraded, and the high withstand voltage makes the piezoelectric element highly reliable over the long term.

In the method for manufacturing a piezoelectric element, an arc discharge reactive ion plating method is preferably used in the step of forming the piezoelectric crystal film.

Using the arc discharge reactive ion plating method makes it possible to efficiently form a piezoelectric crystal film having high quality and high adhesion.

### Brief Description of Drawings

FIG. 1 is a schematic diagram of an optical scanner module including a piezoelectric element according to the present invention.
FIG. 2 is a perspective view of a two-dimensional light deflector included in the optical scanner module.
FIG. 3A is a diagram (1) illustrating the operation of a meander-type piezoelectric actuator of the two-dimensional light deflector.
FIG. 3B is a diagram (2) illustrating the operation of the meander-type piezoelectric actuator of the two-dimensional light deflector.
FIG. 4 is a diagram illustrating the details of the two-dimensional light deflector.
FIG. 5 is a flowchart for manufacturing the piezoelectric element according to the present invention.
FIG. 6 is a diagram illustrating the cross-sectional structure of the piezoelectric element according to the present invention.
FIG. 7 is a diagram illustrating the crystal orientation image of the PZT film of the piezoelectric element of FIG. 6.
FIG. 8 is a diagram illustrating the results of the X-ray diffraction θ-2θ measurement of the PZT film.
FIG. 9 is a diagram illustrating the results of the X-ray rocking curve measurement of the PZT film.
FIG. 10 is a graph illustrating the relationship between the electric field and the leakage current density of the PZT film.
FIG. 11 is a list comparing the measurement results of the withstand field, the endurance time, and the piezoelectric constant of the PZT film with those of a comparative form.

### Description of Embodiments

The following will describe a piezoelectric element according to the present invention and a method for manufacturing the piezoelectric element with reference to the accompanying drawings.

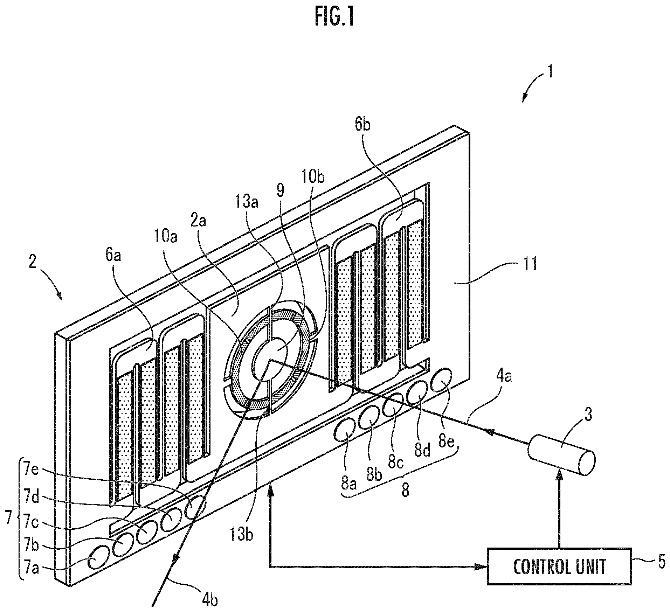

FIG. 1 is a schematic diagram of an optical scanner module 1 including a piezoelectric element of the present invention. The optical scanner module 1 is a device used in, for example, a pico projector, a head-up display, a vehicle headlight, and the like, and is mainly composed of a two-dimensional light deflector 2, a laser light source 3 and a control unit 5.

The two-dimensional light deflector 2 is fabricated using semiconductor processes or MEMS technology, and reflects incident light from a certain direction by a rotating mirror (micromirror 9) thereby to scan and emit the light.

A movable frame 2a of the two-dimensional light deflector 2 has the micromirror 9, semi-annular piezoelectric actuators 10a and 10b, torsion bars (elastic beams) 13a and 13b, and the like. Laser light 4a emitted from the laser light source 3 is incident on the rotating micromirror 9 and reflected, and the scanned emitted light (laser light 4b) scans, for example, the projection surface of a pico projector.

The control unit 5 transmits control signals to the movable frame 2a and the laser light source 3 by wiring, which is not illustrated. The control signals cause the semi-annular piezoelectric actuators 10a and 10b of the movable frame 2a to be driven. Then, the torsion bars 13a and 13b connected to the semi-annular piezoelectric actuators 10a and 10b are twisted thereby to rotate the micromirror 9. Further, the turning on/off and the brightness of the laser light 4a by the laser light source 3 are controlled by the control signals.

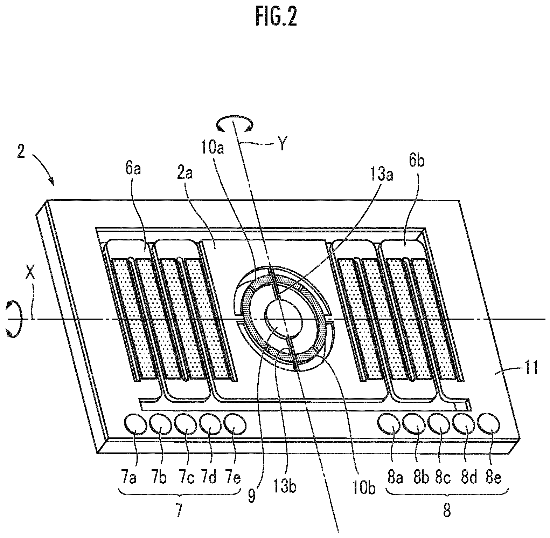

As illustrated in FIG. 2, in the two-dimensional light deflector 2, the movable frame 2a is disposed at the center of an outer frame support 11. In addition, meander-type piezoelectric actuators 6a and 6b are disposed on both sides of the movable frame 2a, and the outer sides of the movable frame 2a and the inner sides of the outer frame support 11 are connected.

The meander-type piezoelectric actuators 6a and 6b have a structure in which a plurality of cantilevers are arranged in parallel with their long sides adjacent to each other, folded back at the vertical ends, and connected in series. As described in detail later, the movable frame 2a rotates in a reciprocating manner in a horizontal direction, i.e., around an X-axis in the drawing, by also driving the meander-type piezoelectric actuators 6a and 6b by the control signals from the control unit 5.

Further, as described above, driving the semi-annular piezoelectric actuators 10a and 10b causes the micromirror 9 to rotate in a reciprocating manner around a Y-axis in the drawing, which coincides with the axes of the torsion bars 13a and 13b.

As a result, when reflecting the laser light 4a by the micromirror 9, the two-dimensional light deflector 2 can emit light to the front of the two-dimensional light deflector 2 and further scan in two directions, namely, an X-axis direction and a Y-axis direction.

The dotted portions of the meander-type piezoelectric actuators 6a and 6b and the semi-annular piezoelectric actuators 10a and 10b are regions of piezoelectric elements in which piezoelectric crystal films are formed. As will be described in detail later, the piezoelectric crystal film is composed of a perpendicularly oriented part oriented along an orientation axis and an obliquely oriented part oriented at a predetermined tilt angle with respect to the orientation axis. Consequently, the piezoelectric elements formed in the piezoelectric actuators are piezoelectric elements having high piezoelectric properties and high long-term reliability.

Electrode pads 7a to 7e (hereinafter referred to as the electrode pads 7) and electrode pads 8a to 8e (hereinafter referred to as the electrode pads 8) are disposed on the lower portion of the outer frame support 11. The electrode pads 7 and 8 are electrically connected such that drive voltages can be applied to the electrodes of the meander-type piezoelectric actuators 6a and 6b and the semi-annular piezoelectric actuators 10a and 10b.

The light deflector functions without the meander-type piezoelectric actuators 6a and 6b. In this case, the light deflector becomes a one-dimensional light deflector in which the portion of the movable frame 2a serves as the outer frame support, and the micromirror 9 rotates in a reciprocating manner around the Y-axis.

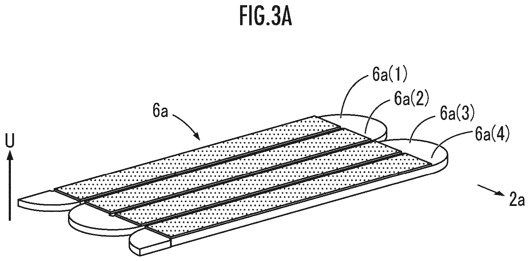

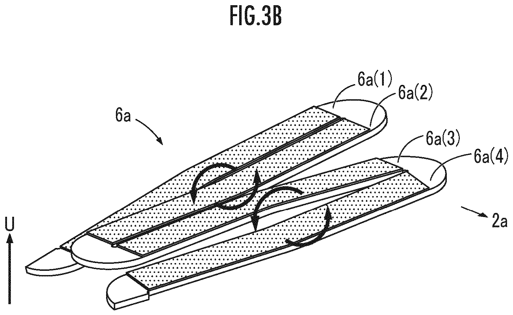

Referring now to FIG. 3A and FIG. 3B, the operation of the meander-type piezoelectric actuator 6a will be described as an example.

As described above, the two-dimensional light deflector 2 enables the micromirror 9 to rotate around the X-axis in a reciprocating manner by operating the meander-type piezoelectric actuators 6a and 6b (hereinafter referred to as the piezoelectric actuators 6a and 6b).

FIG. 3A is a cutout diagram illustrating the piezoelectric actuator 6a disposed on the left side when the two-dimensional light deflector 2 of FIG. 2 is observed from the front side (indicating the side where the piezoelectric crystal films indicated by the dotted portions is seen in a top view, and may also be referred to as "the upward direction"). The piezoelectric actuator 6a has a shape in which four piezoelectric cantilevers are arranged. Further, each piezoelectric cantilever is composed mainly of a piezoelectric crystal film of lead zirconate titanate (PZT: Pb (Zr, Ti) O₃), which is a piezoelectric crystal, and electrode films sandwiching the piezoelectric crystal film, and has a piezoelectric element (details will be described later). Hereinafter, the piezoelectric cantilevers will be referred to as the piezoelectric cantilevers 6a (1), 6a (2), 6a (3), and 6a (4) in order from the one farthest from the movable frame 2a.

For example, in the meander-type piezoelectric actuator 6a, a first voltage is applied to the odd-numbered piezoelectric cantilevers 6a (1) and 6a (3). Further, a second voltage, which is opposite in phase to the first voltage, is applied to the even-numbered piezoelectric cantilevers 6a (2) and 6a (4).

In this way, as illustrated in FIG. 3B, the odd-numbered piezoelectric cantilevers 6a (1) and 6a (3) can be bent and deformed upward (convex in FIG. 3B). Further, the even-numbered piezoelectric cantilevers 6a (2) and 6a (4) can be bent and deformed downward (concave in FIG. 3B).

Although not illustrated, for the piezoelectric actuators 6b, the piezoelectric cantilevers will be referred to as the piezoelectric cantilevers 6b (1), 6b (2), 6b (3), and 6b (4) in order from the one closest to the movable frame 2a. At this time, the odd-numbered piezoelectric cantilevers 6b (1) and 6b (3) can be bent and deformed downward, and the even-numbered piezoelectric cantilevers 6b (2) and 6b (4) can be bent and deformed upward.

Consequently, the micromirror 9 can be displaced such that the lower side of the micromirror 9 (torsion bar 13b side) is pushed up, while the upper side of the micromirror 9 (torsion bar 13a side) is pushed down (the movable frame 2a moves in a U-direction around the X-axis). Similarly, the micromirror 9 can be displaced in the reverse direction by applying a reverse voltage to the piezoelectric cantilevers 6a (1) to (4) and 6b (1) to (4). Thus, the micromirror 9 can be rotated around the X-axis.

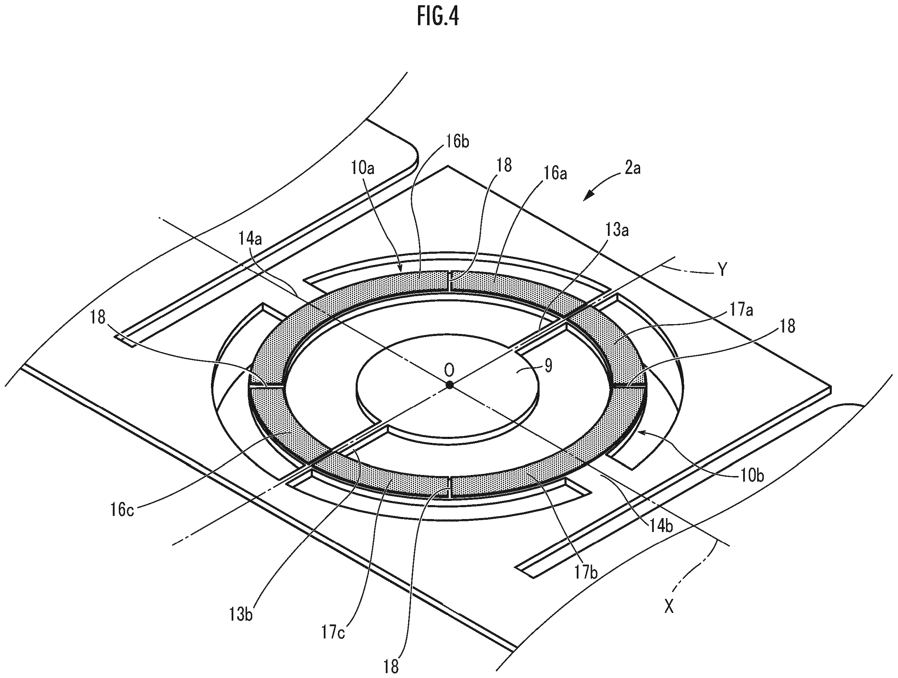

Referring now to FIG. 4, the movable frame 2a will be described in detail.

FIG. 4 is a perspective view of the movable frame 2a observed from the front at an angle. In an initial state, the micromirror 9 directs a normal extending from center O to the front side straight forward.

The circular micromirror 9 is supported by the torsion bars 13a and 13b in the Y-axis direction, and disposed at the center of the movable frame 2a. The reflecting surface of the micromirror 9 is formed by forming a metal thin film of gold (Au), platinum (Pt), aluminum (Al), or the like by, for example, a sputtering method or an electron beam deposition method. The shape of the micromirror 9 is not limited to a circular shape, and may alternatively be an elliptical shape or other shape.

One end of each of the torsion bars 13a and 13b is connected to the micromirror 9, and the other end thereof is connected to the movable frame 2a across the connection to the semi-annular piezoelectric actuators 10a and 10b (hereinafter referred to as the piezoelectric actuators 10a and 10b). The connection of the torsion bars 13a and 13b to the movable frame 2a as described above stabilizes the reciprocating rotation around the Y-axis.

The piezoelectric actuators 10a and 10b are disposed at positions surrounding the micromirror 9 from the outside. The piezoelectric actuators 10a and 10b are connected to the torsion bars 13a and 13b on the Y-axis and connected to fixed bars 14a and 14b, which are a part of the outer frame support 11, on the X-axis.

As will be described in detail later, each of the piezoelectric actuators 10a and 10b also has a piezoelectric element structure in which a PZT piezoelectric crystal film is sandwiched by a lower electrode and an upper electrode by semiconductor planar process. This is a mechanism in which a voltage is applied to the piezoelectric crystal film through the lower electrode and the upper electrode so as to cause the piezoelectric actuators 10a and 10b to bend and deform, thereby twisting the torsion bars 13a and 13b.

Each of the piezoelectric actuators 10a and 10b has dividing grooves 18 formed on straight lines inclined by 45° with respect to the Y-axis, thus dividing the piezoelectric crystal film in the circumferential direction. Further, the torsion bars 13a and 13b extend on the Y-axis, so that the piezoelectric crystal film is divided in the circumferential direction also at these positions.

When fabricating the movable frame 2a by the MEMS technology, first, the piezoelectric crystal film for the piezoelectric actuators 10a and 10b is uniformly formed on the entire circumference including the portions of the torsion bars 13a and 13b. Thereafter, the piezoelectric crystal film is removed by etching from the portions of the torsion bars 13a and 13b and the portions of the dividing grooves 18.

The piezoelectric actuator 10a is divided by the two dividing grooves 18 into sections 16a to 16c in order from the upper side. Meanwhile, the piezoelectric actuator 10b is divided by the two dividing grooves 18 into sections 17a to 17c in order from the upper side.

Consequently, a drive voltage can be individually applied to the piezoelectric crystal film of the sections 16a to 16c and 17a to 17c. For example, the micromirror 9 can be oscillated around the Y-axis by applying a predetermined voltage V1 to the sections 16a, 16c, and 17b, and applying a voltage V2, which has an opposite phase from that of V1, to the sections 16b, 17a, and 17c. By separating the piezoelectric crystal film as described above, the same deflection angle can be obtained with approximately half the voltage in the case of no separation, thus reducing power consumption. Further, the effect of the torsional spring action and reaction by the torsion bars 13a and 13b is also added, thus making it possible to reduce power consumption.

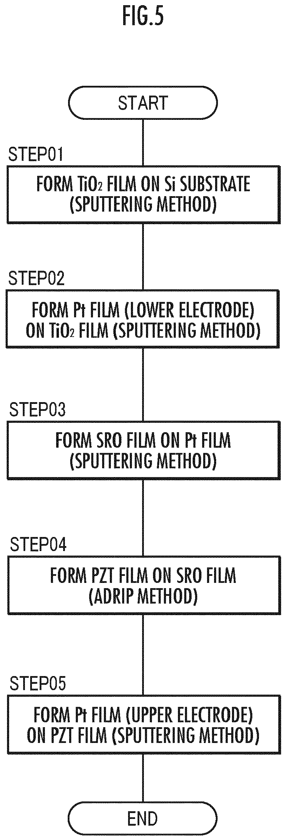

Referring now to FIG. 5 to FIG. 7, the structure of the piezoelectric element formed in each piezoelectric actuator, and the method for manufacturing the piezoelectric element will be described.

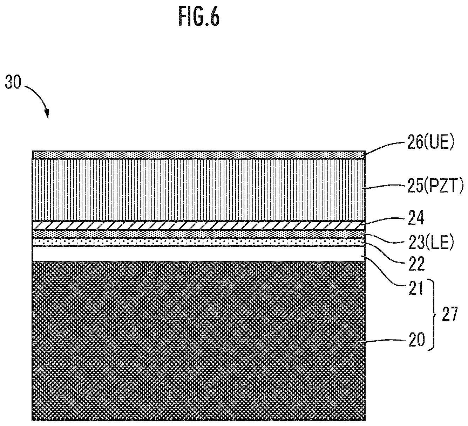

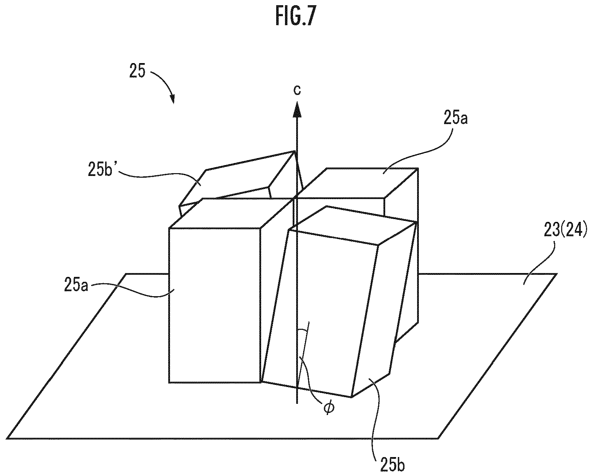

FIG. 5 is a flowchart for manufacturing the piezoelectric element. Further, FIG. 6 illustrates the cross-sectional structure of a piezoelectric element 30 manufactured by the manufacturing method of FIG. 5, and FIG. 7 illustrates the crystal orientation image of the PZT film 25 of the piezoelectric element 30.

First, a plate-shaped Si core substrate 27, on which a silicon oxide (SiO₂) film 21 having a film thickness of approximately 1 µm has been formed, is prepared on the upper surface of a 400µm-thick silicon (Si) substrate 20 (refer to FIG. 6). Then, an amorphous titanium oxide (TiO₂) film 22 made of a metal oxide having a film thickness of 5 nm as an adhesion layer is formed on the Si core substrate 27 at room temperature (e.g., 20°C to 30°C) by a sputtering method (STEP01). The temperature at which the film is formed is the temperature of the Si core substrate 27 on which a film is to be formed.

Subsequently, a conductive Pt film 23 having a film thickness of 200 nm is formed as the lower electrode (a first electrode) on the upper surface of the TiO₂ film 22 at a temperature of 400°C by the sputtering method (STEP02). In this step, the orientation is controlled such that the full width at half maximum (FWHM) of the main peak of the X-ray rocking curve in the (111) surface reflection (diffraction) of the Pt film 23 is 3° ≤ FWHM ≤ 10°.

Subsequently, a SrRuO₃ (SRO) film 24 having a film thickness of 20 nm and a perovskite structure is formed as a buffer layer on the upper surface of the Pt film 23 at a temperature of 750°C by a sputtering method (RF magnetron sputtering) (STEP03).

In the present invention, the amorphous TiO₂ film 22, the Pt film 23 having an X-ray rocking curve FWHM of 3° to 10° in the (111) surface, and the SRO film 24 as a buffer layer are desirably formed by the same apparatus. Alternatively, the films formed in the above-described steps are desirably formed without being exposed to the air by apparatuses connected in a load-lock chamber. This operation makes it possible to improve the crystal orientation properties of the PZT film 25 to be formed in the next step.

Next, a tetragonal PZT film 25 having a film thickness of 4 to 5 µm is formed as a piezoelectric crystal film on the upper surface of the SRO film 24 at a temperature of 550°C by arc discharge reactive ion plating (ADRIP) (STEP04).

The arc discharge reactive ion plating method is a method of forming a film by vaporizing or ionizing a target (PZT) by vacuum arc discharge. Due to the characteristics of arc discharge, the method makes it possible to form a dense film with good adhesion, thus exhibiting high mass-productivity and process stability.

Lastly, a Pt film 26 having a film thickness of 120 nm is formed as the upper electrode (a second electrode) on the upper surface of the PZT film 25 by a sputtering method (STEP05). This completes the piezoelectric element 30 used for the above-described meander-type piezoelectric actuators 6a and 6b, semi-annular piezoelectric actuators 10a and 10b, and the like.

By the steps described above, the piezoelectric element 30 is formed, in which the TiO₂ film 22 as the adhesion layer, the Pt film 23 as the lower electrode (LE) of the upper surface thereof, the SRO film 24 as the buffer layer of the upper surface of the Pt film 23, the PZT film 25 of the upper surface thereof, and the Pt film 26 as the upper electrode (UE) of the upper surface thereof are stacked on the upper surface of the Si core substrate 27 composed of the Si substrate 20 and the SiO₂ film 21, as illustrated in FIG. 6.

The PZT film 25 of the piezoelectric element 30 formed as described above is a polycrystalline film in which a plurality of columnar PZT crystal grains are bound in a direction perpendicular to a surface of the Pt film 23 (SRO film 24) as the lower electrode. In other words, the piezoelectric element 30 has a structure in which the PZT film 25 composed of a group of columnar crystal grains is placed between the surface of the Pt film 23 as the lower electrode and the surface of the Pt film 26 as the upper electrode.

Referring now to FIG. 7, the crystal orientation of the PZT film 25 will be described.

The PZT crystal that forms the PZT film 25 is a tetragonal crystal, and when a <100> direction is defined as an a-axis, a <010> direction is defined as a b-axis, and a <001> direction is defined as a c-axis, the a-axis and b-axis are orthogonal, and the c-axis is orthogonal to a plane containing the a-axis and the b-axis. In addition, the tetragonal crystal is longer in the c-axis direction, and polarized in the c-axis direction.

FIG. 7 is a diagram schematically illustrating two perpendicularly oriented parts 25a and 25a', and two obliquely oriented parts 25b and 25b' of the PZT crystal constituting the PZT film 25. Each of the perpendicularly oriented parts 25a and 25a' and the obliquely oriented parts 25b and 25b' corresponds to one unit of the crystal grains of the polycrystalline film that forms the PZT film 25. Further, each of the perpendicularly oriented parts 25a and 25a', and the obliquely oriented parts 25b and 25b' may coexist in one unit of the polycrystalline body.

In the following description, when the two perpendicularly oriented parts 25a and 25a' are equivalent, these parts will be described simply as "the perpendicularly oriented parts 25a," and when the two obliquely oriented parts 25b and 25b' are equivalent, these parts will be described simply as "the obliquely oriented parts 25b."

In the two perpendicularly oriented parts 25a, the c-axis of the PZT crystal is oriented in a direction perpendicular to the plane of the Pt film 23 (the SRO film 24). Further, in the obliquely oriented parts 25b, the c-axis is obliquely oriented by the tilt angle φ (e.g., φ = 10°) with respect to the c-axis of the perpendicularly oriented parts 25a.

FIG. 7 is a schematic diagram in which the crystal lattice is inclined. However, in the PZT film 25 in which the columnar PZT crystal grains are bound, only the internal orientation axes of the columnar PZT crystal grains are vertical or inclined. Further, although not illustrated, the c-axis of the obliquely oriented part 25b is inclined at an arbitrary angle in the radial direction (in all circumferential directions from 0° to 360°) with respect to the c-axis of the perpendicularly oriented part 25a. The obliquely oriented parts 25b are scattered (dispersed) in the PZT crystal film composed of the perpendicularly oriented parts 25a.

The a-axis (b-axis) of each PZT crystal contained in the PZT film 25 is oriented in various directions, with the c-axis, which is oriented perpendicularly to the surface of the Pt film 23 (the SRO film 24), serving as the rotation axis. In other words, the PZT film 25 is a uniaxially oriented polycrystalline body.

Further, the c-axis of each of the perpendicularly oriented parts 25a and the obliquely oriented parts 25b has an inclination distribution such as, for example, normal distribution. Hereinafter, the c-axis of the perpendicularly oriented parts 25a and the c-axes of the obliquely oriented parts 25b will be referred to in terms of a representative value in individual c-axis distributions (referred to as the principal c-axis in some cases).

When the voltage of the first electrode (the second electrode) is applied to the lower electrode (the Pt film 23) and the upper electrode (the Pt film 26) sandwiching the PZT film 25 composed of the uniaxially oriented polycrystalline body described above, the c-axis stretches (or compresses), and the surface orthogonal to the c-axis is isotropically compressed (or stretched). This causes the piezoelectric actuators 6a, 6b, 10a, and 10b having the piezoelectric elements 30 formed therein to operate as described above. Further, the PZT film 25 isotropically compresses (or stretches) in the film surface direction, thus making the PZT film 25 usable for piezoelectric actuators of any shapes.

Although the above has described the PZT film 25 composed of the PZT crystals containing the perpendicularly oriented parts 25a and the obliquely oriented parts 25b of the present embodiment, the piezoelectric film is not limited to the PZT crystals as long as the piezoelectric film is composed of uniaxially oriented columnar polycrystalline body containing perpendicularly oriented parts and obliquely oriented parts. Materials include, for example, barium titanate (BaTiO₃), lead titanate (PbTiO₃), and (NaK)NbO₃.

Further, the PZT film 25 composed of the uniaxially oriented columnar polycrystalline body containing the perpendicularly oriented parts 25a and the obliquely oriented parts 25b of the present embodiment can be formed by the step of forming the amorphous TiO₂ film 22 on the Si core substrate 27 (STEP01), the step of forming the Pt film 23 (the lower electrode) having an X-ray rocking curve FWHM of 3° to 10° in the (111) surface (STEP02), and the step of forming the PZT crystal (the piezoelectric film) on the multilayer film formed in the step (STEP03) of forming the buffer layer composed of the SRO film 24 (STEP04).

The manufacturing method of the above-described embodiment is merely an example, and the manufacturing method is not limited to the manufacturing method of the present embodiment as long as a piezoelectric film composed of uniaxially oriented columnar polycrystalline body containing perpendicularly oriented parts and obliquely oriented parts is obtained.

A description will now be given of the structure and the film formation method of the piezoelectric element of a comparative form. The piezoelectric element of the comparative form differs from the method for manufacturing the piezoelectric element 30 of the embodiment only in that, after the TiO₂ film is formed (STEP01), the TiO₂ film is annealed and the Pt film is formed at a high temperature. The following will describe only the differences.

A PZT film of the comparative form is formed by forming a TiO₂ film by the sputtering method at room temperature (e.g., 20°C to 30°C), and then annealing the TiO₂ film at a temperature of 750°C by an annealing apparatus to obtain a rutile crystal structure.

Further, a Pt film having a film thickness of 200 nm is formed as a lower electrode on the upper surface of the TiO₂ film by the sputtering method at a temperature of approximately 800°C. The X-ray rocking curve FWHM of the (111) surface of the Pt film formed as described above is below 3°. Thus, the PZT film formed under the same conditions as in the embodiment after the formation of the Pt film is composed only of perpendicularly oriented parts.

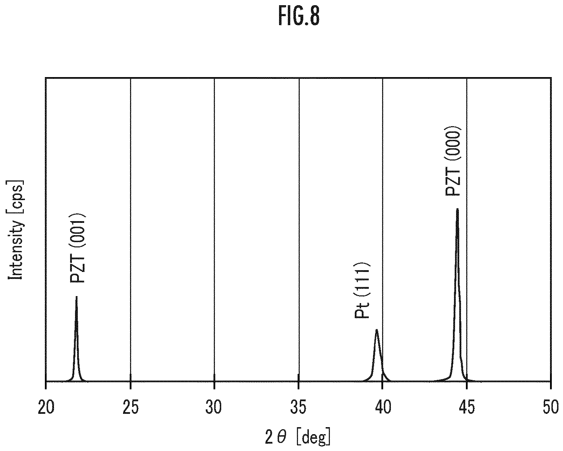

Referring now to FIG. 8 to FIG. 11, various measurement data of the piezoelectric element 30 (the PZT film 25) of the present embodiment and the piezoelectric element of the comparative form will be described.

FIG. 8 illustrates the results of measurement of the PZT film 25 obtained by the X-ray diffraction θ-2θ measurement method. In this measurement, the upper electrode (the Pt film 26) shields X-rays, so that a piezoelectric element not provided with an upper electrode is used. Alternatively, a piezoelectric element may be used, in which the Pt film 26 is partially etched after the Pt film 26 is formed as the upper electrode. The crystal orientation properties of the PZT film 25 will remain unchanged even if the upper electrode is not provided.

The X-ray diffraction (XRD) θ-2θ measurement method is a method for analyzing crystals by utilizing Bragg reflection of X-rays based on crystal surface spacing. Specifically, the measurement method is a method in which X-rays are incident at an angle θ with respect to the crystal surface in the horizontal direction of a sample, and among the X-rays reflected (diffracted) from the sample, a reflected X-ray of an angle 2θ with respect to an incident angle θ of the incident X-ray is detected, and the intensity of the reflected X-ray is determined. When the horizontal surface of the sample is defined as a reference, the incident angle of X-rays is ω, so that the measurement method is expressed as ω-2θ in some cases.

Referring to FIG. 8, the horizontal axis represents a reflected X-ray angle 2θ [deg], and the vertical axis represents a reflected X-ray intensity ([cps: counts per sec]). The scanning angle is 20° to 50°, and Cu-2Kα1 is used for incident X-rays.

As illustrated, in the reflected X-ray intensity curve of the θ-2θ measurement of the PZT film 25 in the present embodiment, only the reflection peaks of a (001) surface of the PZT crystal (c-axis orthogonal surface) at 21.82° and a (002) surface of the PZT crystal (the c-axis orthogonal surface) at 44.44° are detected (the (002) peak is indicated as (000) in Fig. 8). In addition, a reflection peak of a (111) surface of the Pt film 23, which is the lower electrode, is detected at 39.70°. Thus, it can be seen that the PZT crystals of the PZT film 25 are only c-axis oriented with respect to the (111) surface of the Pt film 23.

Further, in the PZT film of the comparative form, as in the embodiment, only the peaks of the (001) surface reflection and the (002) surface reflection of the PZT film, and the (111) surface reflection of the Pt film were observed (not illustrated). This verified that the PZT film of the comparative form is also c-axis oriented through the SRO film on the (111) surface of the Pt film.

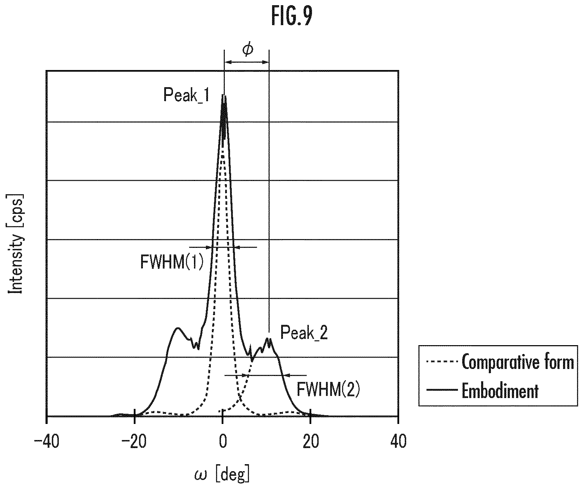

Referring now to FIG. 9, the results of the X-ray rocking curve measurement of the PZT film 25 will be described.

The X-ray rocking curve measurement is a method in which the incident angle θ of X-rays and the reflection angle 2θ of a detector are fixed so as to obtain the reflection of a particular surface of a crystal, a sample table (PZT film) is scanned (ω scan) from the incident direction to the reflection direction, and the orientation distribution of the crystal surface (c-surface), i.e., the distribution of the crystal orientation axis orthogonal to the crystal surface, is determined from the obtained X-ray reflection intensity curve (rocking curve).

FIG. 9 illustrates the rocking curves of the (001) surfaces of the PZT film 25 of the embodiment and the PZT film of the comparative form. Here, the horizontal axis represents the relative angle Δω [deg] with respect to an angle ω, which is a reference (0°) at which the reflected X-ray intensity is maximum, and the vertical axis represents the reflected X-ray intensity [cps] (on a linear scale graduated in 2000 cps steps). The solid line indicates the rocking curve of the PZT film 25 of the embodiment, while the dashed line indicates the rocking curve of the PZT film of the comparative form. The magnification of the reflected X-ray intensity of the comparative form is adjusted such that the maximum value thereof will be the same as that of the embodiment.

The rocking curve of the PZT film 25 of the embodiment (solid line) includes a main peak having the peak (main peak Pm) at Δω = 0°, and subpeaks having peaks, which are different from that of the main peaks, (subpeaks Ps) at two places of Δω = ±10°. The FWHMs of the main peak and the subpeaks were 5.0° and 8.36°, respectively. Further, the intensity ratio Rp of reflected X-ray of the subpeak Ps to the main peak Pm (IntPs/IntPm) was 0.25 (2811/11314) for Rp at the subpeak Ps of Δω = 10, and 0.30 (3358/11314) for Rp at the subpeak Ps of Δω = -10.

In the PZT film 25, substantially the same rocking curve is obtained at any place, and even when the PZT film 25 is rotated. In other words, in the film surface of the PZT film 25, the perpendicularly oriented part 25a and the obliquely oriented part 25b are evenly formed.

Further, when the peak of the main peak (main peak Pm) of the rocking curve is set to Δω=0°, a position Δωps of the peak of the subpeak (subpeak Ps) corresponds to the tilt angle φ of the main c-axis of the obliquely oriented part 25b with respect to the main c-axis of the perpendicularly oriented part 25a. That is, |Δωps| = φ (10° in this case) in the present embodiment.

Thus, the perpendicularly oriented part 25a is a group of crystals having a c-axis inclination distribution in which the FWHM is 5.0°, and the obliquely oriented part 25b is a group of crystals having a c-axis inclination distribution in which the FWHM is 8.36°. Both groups of crystals are discrete groups of crystals that have the c-axis orientations corresponding to the main peak Pm and the subpeak Ps as the centers of distribution. Further, the c-axis of the obliquely oriented part 25b is inclined in all circumferential directions from 0° to 360° with respect to the c-axis of the perpendicularly oriented part 25a. The abundance ratio of the obliquely oriented part 25b to the perpendicularly oriented part 25a is set to an abundance ratio that does not impair the inverse piezoelectric effect (Rp = 0.25 and 0.30 in this case).

Meanwhile, the rocking curve of the PZT film of the comparative form (dashed line) has only a unimodal reflection peak based on the (001) surface at Δω = 0°. The FWHM of the reflection peak was 3.1°. This means that the PZT crystals of the PZT film of the comparative form are composed of only the perpendicularly oriented parts, and the perpendicularly oriented parts are a group of crystals having a c-axis inclination distribution that is narrower than that of the embodiment. In other words, the PZT film of the comparative form is a PZT film in which the crystal orientation of the PZT crystals exhibits high regularity.

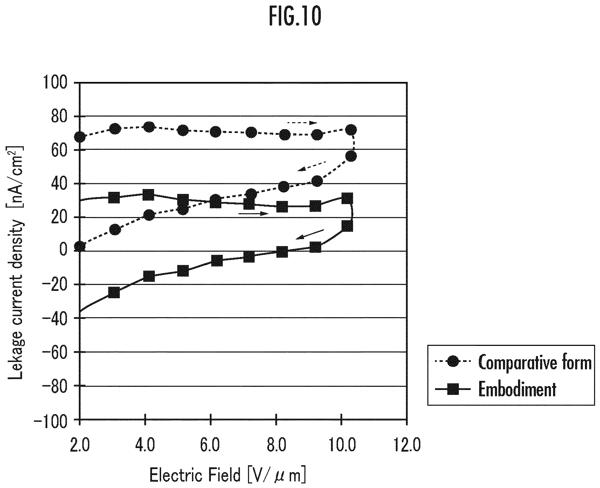

FIG. 10 is a graph illustrating the relationship between the electric field and the leakage current density of the PZT film 25.

In FIG. 10, the horizontal axis represents an electric field [V/µm] applied to the PZT film 25 when a voltage is applied to the lower electrode (the Pt film 23) and the upper electrode (the Pt film 26) of the piezoelectric element 30, and the vertical axis represents the leakage current density [nA/cm²] when a voltage is applied. The relationship between the electric field and the leakage current density of the piezoelectric element 30 of the embodiment is indicated by the solid line, and the relationship between the electric field and the leakage current density of the piezoelectric element of the comparative form is indicated by the dashed line.

In this measurement, after poling (polarizing) the PZT film of the piezoelectric element, the voltage boost side (upper curve) is measured, and then the voltage drop side (lower curve) is measured. The voltage is applied in a pattern of 0[V] → measurement voltage 1 → 0[V] → measurement voltage 2 → and so on. The application of the voltages is performed in regions where the electric field is 2.0 [V/µm] or more, avoiding unstable regions.

The piezoelectric element 30 of the embodiment exhibits a leakage current of approximately 30 [nA/cm²] in the first direction (positive value) when the voltage is boosted (the upper curve of the solid line). Then, when the voltage is stepped down (the lower curve of the solid line), the leakage current flowing in the first direction (positive value) decreases at an electric field of 10.0 to 8.0 [V/µm], the leakage current becomes 0 at an electric field of 8.0 [V/µm], and the leakage current flowing in the second direction (negative value) increases at an electric field of 8.0 to 2.0 [V/µm]. In other words, the piezoelectric element 30 reverses the polarity of the leakage current during voltage step-down except for unstable regions. The reason why the polarity reversal of the leakage current does not immediately take place when the voltage is stepped down is considered to be due to the hysteresis of the piezoelectric crystals.

Meanwhile, the piezoelectric element of the comparative form exhibits a leakage current of approximately 70 [nA/cm²] in the first direction (positive value) when the voltage is boosted (the upper curve of the dashed line). Then, when the voltage is stepped down (the lower curve of the dashed line), the leakage current flowing in the first direction (positive value) at an electric field of 10.0 to 2.0 [V/µm] decreases to approximately 70 to 0 [nA/cm²].

As described above, in the piezoelectric element 30 of the embodiment, when a voltage is applied to the electrodes (the Pt film 23 and the Pt film 26), the leakage current increases when the voltage is boosted and decreases when the voltage is stepped down. In addition, in an early stage of a step-down period, the leakage current reverses its flowing direction and increases. On the other hand, in the piezoelectric element of the comparative form, the leakage current increases when a voltage is boosted, and decreases when the voltage is stepped down.

Such a characteristic that the leakage current reverses its flowing direction and increases when a voltage is stepped down is considered to be due to improved leakage current resistance characteristics during the crystal deformation of the PZT film 25 when the reverse piezoelectric effect (piezoelectric element deformation) is exerted on the piezoelectric element 30 of the embodiment.

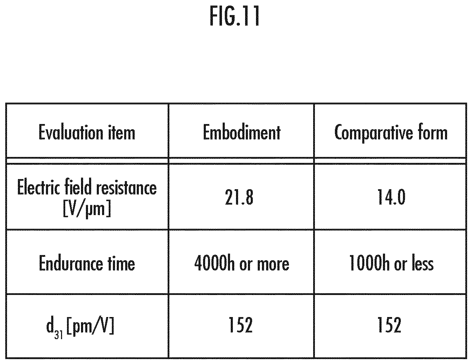

Lastly, FIG. 11 is a list comparing the measurement results of the electric field resistance, which is the operating limit electric field of the piezoelectric element 30 of the embodiment and the piezoelectric element of the comparative form, and the endurance time and a piezoelectric constant d₃₁ in an endurance test simulating the operating conditions of the meander-type piezoelectric actuators 6a and 6b and the semi-annular piezoelectric actuators 10a and 10b used for the two-dimensional light deflector 2.

The electric field resistance, the endurance time, and the piezoelectric constant d₃₁ of the piezoelectric element 30 of the embodiment are 21.8 [V/µm], 4000 hrs. or more, and 152 [pm/V], respectively. Meanwhile, the electric field resistance, the endurance time, and the piezoelectric constant d₃₁ of the piezoelectric element of the comparative form are 14.0 [V/µm], 1000 hrs. or less, and 152 [pm/V], respectively. Both the electric field resistance and the endurance time have been improved over the piezoelectric element 30 of the comparative embodiment. In addition, regarding the piezoelectric constant d₃₁, characteristics equivalent to those of the piezoelectric element of the comparative form are obtained even in the case of the piezoelectric element 30 of the embodiment provided with the obliquely oriented parts 25b.

The piezoelectric element 30 of the present embodiment has improved electric field resistance and endurance time due to the structure described below.

Firstly, the PZT crystal that forms the PZT film 25 of the present embodiment is a columnar uniaxially oriented polycrystalline body in which the c-axis of the tetragonal crystal is oriented in the direction orthogonal to the film surface of the Pt film 23 (the SRO film 24) (the directions of the a-axis and the b-axis are arbitrary). Secondly, the columnar uniaxially oriented polycrystalline body is provided with the perpendicularly oriented parts 25a and the obliquely oriented parts 25b. In addition, the obliquely oriented parts 25b are dispersed on the film surface of the PZT film 25. Thirdly, the c-axis of the perpendicularly oriented part 25a and the c-axis of the obliquely oriented part 25b are provided with the inclination distributions (each of the main peak and the subpeaks has an axis distribution).

With the above-described structure, the film strain that occurs when the PZT crystal is deformed by applying an electric field to the PZT film 25 can be dispersed throughout the PZT film 25 so as to be mitigated. This makes it possible to improve the electric field resistance characteristic and to prolong the endurance time. In particular, the leakage current resistance characteristic is improved by providing the c-axis of the obliquely oriented part 25b spaced apart (dispersedly) by an angle φ from the c-axis of the perpendicularly oriented part 25a, so that the endurance time can be prolonged.

To improve the electric field resistance and the endurance time, the tilt angle φ of the c-axis of the obliquely oriented part 25b is preferably set to be larger than 6° and below 19°. This is because, if the tilt angle φ of the c-axis of the obliquely oriented part 25b is set to 6° or less, then the electric field resistance and the endurance time deteriorate due to assimilation to the angle distribution of the c-axis of the perpendicularly oriented part 25a. Further, if the tilt angle φ of the c-axis of the obliquely oriented part 25b is set to 19° or more, then a <111> axis appears, and the piezoelectric properties of the PZT film deteriorate. In addition, the tilt angle φ is ideally set to 7° or more and 13° or less, considering the angle distribution of the c-axis of the obliquely oriented part 25b.

Further, preferably, the abundance ratio of the obliquely oriented part 25b of the PZT film 25 is such that the reflected X-ray intensity ratio Rp is 0.1 to 1. If Rp is below 0.1, then the effect of the obliquely oriented part 25b cannot be obtained. Further, if Rp is greater than 1, then the disturbance of the c-axis orientation of the PZT film 25 becomes excessive, causing the piezoelectric constant d₃₁ to lower. A preferable Rp is 0.15 or more at which the improvement of the electric field resistance characteristic by the obliquely oriented part 25b is saturated, or 0.45 or less at which an improved endurance life value does not decrease.

As described above, the PZT crystals forming the PZT film 25 of the piezoelectric element 30 of the embodiment include the perpendicularly oriented parts 25a having the c-axes in the direction orthogonal to the plane of the Pt film 23 (SRO film 24) and the obliquely oriented parts 25b having the c-axes inclined (tilted) by the angle φ with respect to the c-axes of the perpendicularly oriented part 25a. Further, the PZT crystals allow for the high withstand voltage, the prolonged endurance time, and the piezoelectric constant of d₃₁ that is not compromised. This enables the piezoelectric element 30 of the present invention to provide a highly reliable two-dimensional light deflector.

In addition, the improved withstand voltage and endurance time of the piezoelectric element 30 of the embodiment makes it possible to, for example, apply a higher voltage (electric field) to the piezoelectric element 30 to increase the range of movement of the actuators.

The above has described the embodiment for implementing the present invention; however, the present invention is not limited to the above-described embodiment, and modifications can be made within the scope of the present invention as defined by the appended claims.

For example, in FIG. 6, the thicknesses of the thin films constituting the piezoelectric element 30 and the methods for forming the films are merely examples, and can be changed. The piezoelectric crystal film may be made of a material having piezoelectric properties other than PZT. In addition, the TiO₂ film 22 as the adhesion layer and the SRO film 24 as the buffer layer are not constituents essential to the piezoelectric element of the present invention, and may be omitted.

## Claims

1. A piezoelectric element comprising:
a substrate (27), at least one surface of which is a plane;
a first electrode film (23) provided on the plane of the substrate (27);
a tetragonal piezoelectric crystal film (25) provided on the first electrode film (23); and
a second electrode film (26) provided on a surface of the piezoelectric crystal film (25), the surface facing the first electrode film (23),
wherein the piezoelectric crystal film (25) is a uniaxially oriented polycrystalline body composed of columnar crystal grains with a c-axis of the tetragonal crystal oriented in a direction perpendicular to the first electrode film (23),
the polycrystalline body includes a perpendicularly oriented part (25a) having a c-axis in a direction perpendicular to the first electrode film (23) and an obliquely oriented part (25b, 25b') having a c-axis inclined with respect to the c-axis of the perpendicularly oriented part (25a), and
each of the c-axis of the perpendicularly oriented part (25a) and the c-axis of the obliquely oriented part (25b, 25b') has a distribution, and a c-axis distribution of the obliquely oriented part (25b, 25b') is discrete with respect to a c-axis distribution of the perpendicularly oriented part (25a);
**characterized in that**
an intensity ratio Rp in an X-ray rocking curve of the obliquely oriented part (25b, 25b') to the perpendicularly oriented part (25a) is 0.1 to 1.

2. The piezoelectric element according to claim 1, wherein the c-axis of the obliquely oriented part (25b, 25b') is inclined in all circumferential directions from 0° to 360°, the c-axis of the perpendicularly oriented part (25a) being a rotation axis.

3. The piezoelectric element according to any one of claims 1 to 2, wherein a tilt angle φ of the c-axis of the obliquely oriented part (25b, 25b') with respect to the c-axis of the perpendicularly oriented part (25a) of the piezoelectric crystal film (25) is greater than 6° and below 19°.

4. The piezoelectric element according to any one of claims 1 to 3, wherein the piezoelectric crystal film (25) is lead zirconate titanate and the first electrode film (23) is platinum.

5. The piezoelectric element according to any one of claims 1 to 4, wherein a film surface of the first electrode film (23) is a (111) surface.

6. The piezoelectric element according to any one of claims 1 to 5, wherein the substrate (27) is a plate-shaped Si core substrate, in which a silicon oxide, SiO₂, film (21) has been formed on an upper surface of a silicon, Si, substrate (20).

7. The piezoelectric element according to any one of claims 1 to 6, further having an adhesion layer (22) of an amorphous titanium oxide, TiO₂, film on the substrate (27),
the first electrode film (23) being provided on the substrate (27) via the adhesion layer (22),
a buffer layer (24) of a SrRuO₃, SRO, film having a perovskite structure is formed on the first electrode film (23), and
the piezoelectric crystal film (25) is provided on the first electrode film (23) via the buffer layer (24).

## Patentansprüche

1. Ein piezoelektrisches Element, das Folgendes umfasst:
ein Substrat (27), von dem mindestens eine Oberfläche eine Ebene ist;
einen ersten Elektrodenfilm (23), der auf der Ebene des Substrats (27) vorgesehen ist;
einen tetragonalen piezoelektrischen Kristallfilm (25), der auf dem ersten Elektrodenfilm (23) vorgesehen ist; und
einen zweiten Elektrodenfilm (26), der auf einer Oberfläche des piezoelektrischen Kristallfilms (25) vorgesehen ist, wobei die Oberfläche dem ersten Elektrodenfilm (23) zugewandt ist,
wobei der piezoelektrische Kristallfilm (25) ein uniaxial ausgerichteter polykristalliner Körper ist, der aus säulenförmigen Kristallkörnern mit einer c-Achse des tetragonalen Kristalls besteht, die in einer Richtung senkrecht zum ersten Elektrodenfilm (23) ausgerichtet ist,
wobei der polykristalline Körper einen senkrecht ausgerichteten Teil (25a) mit einer c-Achse in einer Richtung senkrecht zu dem ersten Elektrodenfilm (23) und einen schräg ausgerichteten Teil (25b, 25b') mit einer c-Achse, die in Bezug auf die c-Achse des senkrecht ausgerichteten Teils (25a) geneigt ist, umfasst, und
wobei jeweils die c-Achse des senkrecht ausgerichteten Teils (25a) und die c-Achse des schräg ausgerichteten Teils (25b, 25b') eine Verteilung aufweisen und eine c-Achsen-Verteilung des schräg ausgerichteten Teils (25b, 25b') in Bezug auf eine c-Achsen-Verteilung des senkrecht ausgerichteten Teils (25a) diskret ist;
**dadurch gekennzeichnet, dass**
ein Intensitätsverhältnis Rp in einer Röntgen-Rocking-Kurve des schräg ausgerichteten Teils (25b, 25b') zum senkrecht ausgerichteten Teil (25a) 0,1 bis 1,2 beträgt.

2. Piezoelektrisches Element nach Anspruch 1, wobei die c-Achse des schräg ausgerichteten Teils (25b, 25b') in allen Umfangsrichtungen von 0° bis 360° geneigt ist, wobei die c-Achse des senkrecht ausgerichteten Teils (25a) eine Rotationsachse ist.

3. Piezoelektrisches Element nach einem der Ansprüche 1 bis 2, wobei ein Neigungswinkel φ der c-Achse des schräg ausgerichteten Teils (25b, 25b') in Bezug auf die c-Achse des senkrecht ausgerichteten Teils (25a) des piezoelektrischen Kristallfilms (25) größer als 6° und kleiner als 19° ist.

4. Piezoelektrisches Element nach einem der Ansprüche 1 bis 3, wobei der piezoelektrische Kristallfilm (25) Blei-Zirkonat-Titanat ist und der erste Elektrodenfilm (23) Platin ist.

5. Piezoelektrisches Element nach einem der Ansprüche 1 bis 4, wobei eine Filmoberfläche des ersten Elektrodenfilms (23) eine (111)-Oberfläche ist.

6. Piezoelektrisches Element nach einem der Ansprüche 1 bis 5, wobei das Substrat (27) ein plattenförmiges Si-Kernsubstrat ist, in dem ein Siliziumoxid-Film, SiO₂, (21) auf einer oberen Oberfläche eines Silizium-Substrats, Si, (20) ausgebildet wurde.

7. Piezoelektrisches Element gemäß einem der Ansprüche 1 bis 6, das ferner eine Haftschicht (22) aus einem Film aus amorphem Titanoxid, TiO₂, auf dem Substrat (27) aufweist,
wobei der erste Elektrodenfilm (23) auf dem Substrat (27) mittels der Haftschicht (22) vorgesehen ist,
wobei eine Pufferschicht (24) aus einem SrRuO₃, SRO, -Film mit einer Perowskit-Struktur auf dem ersten Elektrodenfilm (23) ausgebildet ist, und
wobei der piezoelektrische Kristallfilm (25) auf dem ersten Elektrodenfilm (23) mittels der Pufferschicht (24) vorgesehen ist.

## Revendications

1. Élément piézoélectrique comprenant
un substrat (27) dont au moins une surface est plane ;
un premier film d'électrode (23) placé sur le plan du substrat (27) ;
un film de cristal piézoélectrique tétragonal (25) placé sur le premier film d'électrode (23) ; et
un deuxième film d'électrode (26) placé sur une surface du film de cristal piézoélectrique (25), la surface faisant face au premier film d'électrode (23),
dans lequel le film cristallin piézoélectrique (25) est un corps polycristallin à orientation uniaxiale composé de grains de cristal colonnaires avec un axe c du cristal tétragonal orienté dans une direction perpendiculaire au premier film d'électrode (23),
le corps polycristallin comprend une partie orientée perpendiculairement (25a) ayant un axe c dans une direction perpendiculaire au premier film d'électrode (23) et une partie orientée obliquement (25b, 25b') ayant un axe c incliné par rapport à l'axe c de la partie orientée perpendiculairement (25a), et
l'axe c de la partie orientée perpendiculairement (25a) et l'axe c de la partie orientée obliquement (25b, 25b') ont chacun une distribution, et une distribution de l'axe c de la partie orientée obliquement (25b, 25b') est discrète par rapport à une distribution de l'axe c de la partie orientée perpendiculairement (25a) ;
**caractérisé en ce que**
un rapport d'intensité Rp dans une courbe de bascule des rayons X de la partie orientée obliquement (25b, 25b') par rapport à la partie orientée perpendiculairement (25a) est compris entre 0,1 et 1.

2. L'élément piézoélectrique selon la revendication 1, dans lequel l'axe c de la partie orientée obliquement (25b, 25b') est incliné dans toutes les directions circonférentielles de 0° à 360°, l'axe c de la partie orientée perpendiculairement (25a) étant un axe de rotation.

3. L'élément piézoélectrique selon l'une quelconque des revendications 1 à 2, dans lequel un angle d'inclinaison φ de l'axe c de la partie orientée obliquement (25b, 25b') par rapport à l'axe c de la partie orientée perpendiculairement (25a) du film cristallin piézoélectrique (25) est supérieur à 6° et inférieur à 19°.

4. L'élément piézoélectrique selon l'une des revendications 1 à 3, dans lequel le film cristallin piézoélectrique (25) est du titanate de zirconate de plomb et le film de la première électrode (23) est du platine.

5. L'élément piézoélectrique selon l'une des revendications 1 à 4, dans lequel la surface du film de la première électrode (23) est une surface (111).

6. L'élément piézoélectrique selon l'une des revendications 1 à 5, dans lequel le substrat (27) est un substrat à noyau de Si en forme de plaque, dans lequel un film d'oxyde de silicium, SiO₂, (21) a été formé sur une surface supérieure d'un substrat de silicium, Si, (20).

7. L'élément piézoélectrique selon l'une des revendications 1 à 6, comportant en outre une couche d'adhésion (22) d'un film d'oxyde de titane amorphe, TiO₂, sur le substrat (27),
le film de la première électrode (23) étant placé sur le substrat (27) par l'intermédiaire de la couche d'adhésion (22),
une couche tampon (24) d'un film de SrRuO₃, SRO, ayant une structure de pérovskite est formée sur le premier film d'électrode (23), et
le film cristallin piézoélectrique (25) est placé sur le premier film d'électrode (23) par l'intermédiaire de la couche tampon (24).
